# EUROPEAN PATENT APPLICATION

(11) **EP 4 421 681 A1**
(43) Date of publication of application: **28.08.2024**
(21) Application number: 24159482.9
(22) Date of filing: 23.02.2024
(51) Int. Cl.: G06K 19/077, H05K 1/14

(54) **WIRELESS TAG**

(30) Priority: 24.02.2023 CN 202310165652; 04.08.2023 CN 202310986505; 01.12.2023 CN 202323276175 U
(71) Applicant: Techtronic Cordless GP, Anderson, SC 29621 (US)
(72) Inventor: LIU, Ya Bin, Dongguan City, 523945 (CN); ZHAO, Jiang, Dongguan City, 523945 (CN); WANG, Ren Jie, Dongguan City, 523945 (CN)
(74) Representative: Novagraaf Group

(57) **Abstract**

The present application provides a wireless tag comprising a wireless communication module, a battery, a first circuit board, and a second circuit board. The wireless communication module is capable of wirelessly communicating with an electronic device and is installed on the first circuit board and electrically connected thereto. The battery is installed on the second circuit board, which is stacked on and electrically connected to the first circuit board, for providing power to the wireless communication module. According to a technical solution of the present application, a circuit board is used as a medium for transferring electric energy between a wireless communication module and a battery, and as a framework supporting the wireless communication module and the battery, which is conducive to reducing the size of the wireless tag to make it compact in structure for ease of assembly, production, installation, and maintenance.

## Description

### Technical Field

The present application relates to a wireless tag, particularly a wireless tag capable of communicating with and being located by an electronic device.

### Background Art

In their daily life and work, people often need to receive and store objects or tools or monitor objects or tools that are not directly observable. People hope to be able to find an object or tool in a timely manner when needed, or to obtain information about a monitored object or tool in a timely manner. For this purpose, a wireless tag may be attached to an object or tool to locate, track, or monitor it. However, most existing wireless tags have simple functions and large sizes, which make it difficult to meet usage needs. Moreover, wireless tags typically use replaceable batteries for power supply. Replacing a flat battery poses a risk of reversing the positive and negative poles of the battery.

Therefore, it is hoped to provide a wireless tag for improving the above problems.

### Summary of the Invention

An objective of the present application is to provide a compact and small-sized wireless tag.

According to one aspect of the present application, the wireless tag comprises:
a wireless communication module capable of wirelessly communicating with an electronic device;
a battery for powering the wireless communication module;
a first circuit board, wherein the wireless communication module is installed on the first circuit board and electrically connected to the first circuit board; and
a second circuit board stacked on and electrically connected to the first circuit board, the battery being installed on the second circuit board.

In some embodiments, the first circuit board is constructed as a U-shaped structure, the two opposite side arms of the U-shaped structure are constructed as guide rails, the opposite sides of the wireless communication module are provided with grooves, and the wireless communication module is installed on the first circuit board through a fit between the guide rails and the grooves.

In some embodiments, a chamfer is provided at one end of the groove facing the first circuit board.

In some embodiments, the wireless communication module is connected to the first circuit board through a pin connector, wherein the direction of plugging of the wireless communication module into the pin connector is parallel to the extension direction of the groove.

In some embodiments, the direction of plugging of the pin connector into the first circuit board is perpendicular to the extension direction of the groove.

In some embodiments, the first circuit board and the second circuit board are electrically connected through a pin connector, wherein the pin connector comprises a support member sleeved on a pin, the support member being supported between the first circuit board and the second circuit board.

In some embodiments, a plurality of pin connectors are spaced at intervals along the circumference of the first or second circuit board.

In some embodiments, the battery is a button battery, and the battery installation part comprises a first terminal that protrudes elastically outwards from the surface of the second circuit board and a plurality of second terminals that extend outwards from the surface of the second circuit board around the first terminal, wherein in the state where the button battery is installed in the battery installation part, the first terminal elastically abuts an end face of the button battery, and the second terminal abuts the side of the button battery.

In some embodiments, at least one of the second terminals is provided with a contact arm extending along the circumference of the button battery.

In some embodiments, the battery is a button battery, the battery installation part comprises a first terminal and a second terminal that are spaced at intervals along the direction perpendicular to the plane of the second circuit board, and the button battery is sandwiched between the first terminal and the second terminal.

In some embodiments, the first terminal comprises
two opposite sidewalls, which are connected to the second circuit board and extend in a direction away from the second circuit board, and
a top wall connected to two opposite sidewalls at a distance from the second circuit board.

In some embodiments, one end of the first terminal is formed with a battery installation opening facing laterally, and the top wall is provided with a first elastic sheet extending obliquely towards the second circuit board.

In some embodiments, the angle between the component of the extension direction of the first elastic sheet in the direction parallel to the second circuit board and the installation direction of the battery through the battery installation opening is smaller than 90°.

In some embodiments, the free end of the first elastic sheet is formed with a rounded or bent angle on the side facing the battery.

In some embodiments, the first terminal comprises a blocking part arranged at one end opposite to the battery installation opening, the blocking part being configured to prevent further movement of the battery along the installation direction.

In some embodiments, the blocking part is connected to the top wall and extends from the top wall towards the second circuit board.

In some embodiments, the first terminal is constructed to be integrally moulded.

In some embodiments, the second terminal comprises a second elastic sheet, one end of which is fixed to the second circuit board and the other end of which is formed as a free end facing outwards relative to the surface of the second circuit board and extending obliquely away from the battery installation opening.

In some embodiments, the angle between the component of the extension direction of the second elastic sheet in the direction parallel to the second circuit board and the installation direction of the battery through the battery installation opening is smaller than 90°.

In some embodiments, the free end of the second elastic sheet is formed with a rounded or bent angle on the side facing the battery.

In some embodiments, the wireless tag further comprises a housing, wherein the assembly formed by the wireless communication module, the battery, the first circuit board, and the second circuit board are accommodated within the housing, and the wireless tag further comprises a bias member arranged between the assembly and the inner wall of the housing and pressing the assembly.

In some embodiments, the wireless tag further comprises a battery installation part for installing a battery, the battery being used for powering the wireless tag, wherein the battery installation part is provided on the second circuit board and has a battery foolproof structure that can prevent the positive and negative electrodes of the battery from being reversed.

In some embodiments, the battery is a button battery having a first end and a second end opposite to each other along the thickness direction, the radial size of the first end is smaller than that of the second end, the first end forms one of the positive and negative electrodes of the button battery, and the second end forms the other of the positive and negative electrodes of the button battery; the battery installation part has a battery installation opening and is constructed to allow the button battery to be plugged into the battery installation part radially along its own direction through the battery installation opening, and the battery foolproof structure is at least partially located at the battery installation opening, wherein the battery foolproof structure divides the battery installation opening into a first passage part and a second passage part along the thickness direction of the button battery, the first passage part having a passage size greater than the radial size of the first end of the button battery and smaller than the radial size of the second end of the button battery, the second passage part having a passage size greater than the radial size of the second end of the button battery.

In some embodiments, the battery installation part comprises a first terminal and a second terminal. The first terminal has a top and two opposite sidewalls, the sidewalls being connected to the circuit board and extending in a direction away from the circuit board. The top wall is connected to two opposite sidewalls at a distance from the circuit board. The second terminal is arranged on the circuit board and is opposite to the top wall.

In some embodiments, the battery foolproof structure has a protrusion, wherein the battery foolproof structure is attached to the first terminal, and when viewed in the direction of plugging of the button battery into the battery installation part, the protrusion is located within the projection range of the battery installation opening.

In some embodiments, a chamfer is provided on the inner side of the protrusion, so that the passage size of the first passage part gradually decreases in the direction away from the second passage part.

In some embodiments, the battery foolproof structure comprises two, which are symmetrically arranged relative to a mid-separate surface that is parallel to the direction of plugging of the button battery and bisects the first terminal.

In some embodiments, the battery foolproof structure is provided with an inverted buckle, which clamps tightly on the sidewall of the first terminal.

In some embodiments, the battery foolproof structure has a main body extending along the direction of plugging of the button battery, wherein the main body is provided with a snap protrusion and/or a snap groove, and the first terminal is provided with a snap groove and/or a snap protrusion, the battery foolproof structure being attached to the first terminal through a snap fit between a snap protrusion and a snap groove.

In some embodiments, the battery foolproof structure is attached to the sidewall of the first terminal.

In some embodiments, the main body is provided with said protrusions at both ends along its own length direction.

In some embodiments, the battery foolproof structure is an insulated foolproof structure.

According to a technical solution of the present application, a circuit board is used as a medium for transferring electric energy between a wireless communication module and a battery, and as a framework supporting the wireless communication module and the battery, which is conducive to reducing the size of the wireless tag to make it compact in structure for ease of assembly. In addition, due to its structural characteristics, it is easy to produce, install, and maintain.

### Brief Description of the Drawings

To better understand the above and other objectives, features, advantages and functions of the present application, reference may be made to the preferred embodiments shown in the drawings. In the drawings, identical reference signs denote identical components. Those of ordinary skill in the art should understand that the drawings are intended to illustrate preferred embodiments of the present application schematically, without limiting effect on the scope of the present application, and that the various components in the drawings are not drawn to scale.
Fig. 1 is a three-dimensional view of a wireless tag according to a preferred embodiment of the present application;
Fig. 2 is a three-dimensional exploded view of the wireless tag shown in Fig. 1;
Fig. 3 is a three-dimensional exploded view of the functional assembly of the wireless tag shown in Fig. 1; and
Fig. 4 is another structure of the battery installation part of the wireless tag;
Fig. 5 is a schematic diagram of the battery installation part in Fig. 4 observed along the direction of plugging of a battery, where a battery is installed in the battery installation part;
Fig. 6 is a three-dimensional view of the positive terminal of the battery installation part in Fig. 4; and
Fig. 7 is a three-dimensional view of a battery foolproof structure.

### Specific Embodiments

Specific embodiments of the present application will be described in detail below by referring to the drawings. The embodiments described herein are merely preferred embodiments of the present application. Based on these preferred embodiments, those of ordinary skill in the art will be able to think of other ways in which the present application could be implemented, all of which likewise fall within the scope of the present application.

The present application provides a wireless tag that has wireless communication function, capable of communicating with an electronic device that also has wireless communication function, which allows the use of an electronic device to locate, track, or monitor an object associated with the wireless tag. A wireless tag may be moved and placed independently or together with an object associated therewith. The object may be associated with a wireless tag by, for example, fixation with a fastener, pasting, or binding with a flexible tape.

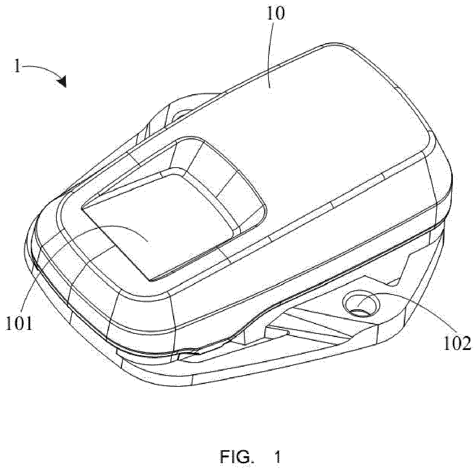

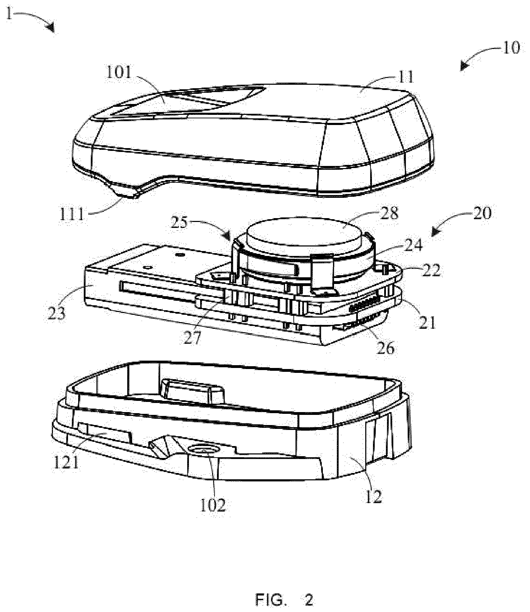

As shown in Fig. 1 and Fig. 2, in some embodiments, the wireless tag 1 may comprise a housing 10 and a functional assembly 20 arranged in the housing 10. The housing 10 can isolate the functional assembly 20 from the external environment, so that the functional assembly 20 is protected from hazards, such as impacts, from the external environment, while a sealing element may be arranged to reduce the possibility of entry of any water, dust, or another substance from the external environment into the component. The housing 10 may be composed of at least two parts. In some embodiments, the housing 10 may comprise three parts: a first housing 11, a second housing 12, and a sealing element (not shown) sandwiched therebetween. The sealing element may be hidden inside the housing 10 or constructed to be visible from the outside.

In some embodiments, the first housing 11 and the second housing 12 are combined by means of a fit, and an accommodating space is formed therebetween. The functional assembly 20 is arranged in the accommodating space. In the illustrated embodiment, at least one of the first housing 11 and the second housing 12 may be provided with a buckle 111, and the other may be correspondingly provided with a buckling position 121 at a position corresponding to the buckle 111, so that the first housing 11 and the second housing 12 are connected and fixed by the buckles. In some other embodiments, the first housing 11 and the second housing 12 may further be connected by fasteners such as screws or rivets, or by threaded structures, or by interference fit. It is understandable that the connection between the two housing parts may be established by one method or a combination of a plurality of methods. In addition, although not shown in the figures, the housing 10 may further comprise a sealing element sandwiched between the first housing 11 and the second housing 12, providing a good seal for the accommodating space under the compression by the two housings.

An installation structure is further provided on the housing 10. During use, the wireless tag 1 may, by the installation structure, be attached to an object to be located, tracked, or monitored, so that the wireless tag 1 is associated with the object. For example, the installation structure may comprise an adhesive sticker located on the surface of the housing 10, wherein the backing paper of the adhesive sticker on the wireless tag 1 may be peeled off before the tag is attached to an associated object. The installation structure may further comprise a flexible belt for fixing the wireless tag 1 to an object. In this case, the housing 10 may further comprise an installation port located on the first housing 11 and/or the second housing 12, through which a flexible belt may pass, so that the wireless tag 1 is bound by the flexible belt more securely to an associated object. In addition, the installation structure may further comprise an installation hole 102 arranged on the housing 10, and the wireless tag 1 may be fixed, with fasteners such as screws or rivets, to an associated object through the installation hole 102. In different embodiments, the installation structure may comprise any one or more of the methods described.

In addition, an identification area 101 is further provided on the housing 10. A unique identification ID may be set for each wireless tag 1 in the identification area 101, which may be a barcode, quick response code, or any other code that indicates the unique identity of the wireless tag 1. A user can establish a wireless communication connection to the wireless tag 1 by manually entering or scanning the identification ID on an electronic device. Preferably, to ensure the accuracy of coded identification for barcodes, quick response codes, etc., the identification area 101 is preferably arranged as a plane to avoid distortion of the coding due to unevenness.

The functional assembly 20 comprises a wireless communication module, a circuit board, and a power source. According to the present application, the various components of functional assembly 20 form a small and compact structure through structural coordination, which is easy to assemble, produce and maintain, while saving space. In some embodiments, the functional assembly 20 comprises a plurality of circuit boards, each of which not only fulfils its own functions but may also be used as a support for another functional assembly, etc. In some embodiments, the circuit board comprises a first circuit board 21 and a second circuit board 22 that are separately arranged. The first circuit board 21 is used as a support for the wireless communication module 23, while the second circuit board 22 is used as a support for the power source. Therefore, the circuit board simultaneously serves the purposes of establishment of an electrical connection, control, and support, allowing for a reduction in the number of components.

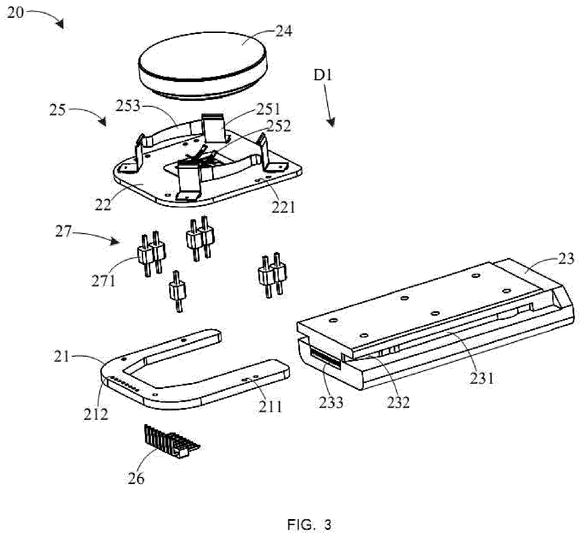

The wireless tag 1 can use a battery 24 integrated therewith as a power source. As shown in Fig. 2 and Fig. 3, in some embodiments, the battery 24 used by the wireless tag 1 is preferably a button battery. Compared with other types of batteries, a button battery has a smaller volume, which is beneficial for reducing the size of the wireless tag 1. The second circuit board 22 is provided with a battery installation part 25. The battery 24 is fixed to the second circuit board 22 by the battery installation part 25. Specifically, the battery installation part 25 forms a battery chamber for accommodating a battery, wherein a negative terminal 252 is provided at the bottom of the battery chamber, and a positive terminal 251 protruding upwards relative to the second circuit board 22 is formed on the periphery of the battery chamber. A plurality of (for example, four) positive terminals 251 may be spaced at intervals along the circumference of the battery chamber to enclose a space for accommodating a battery. It is understandable that the number of positive terminals 251 may be flexibly selected on the basis of the specific size of the battery 24. Preferably, at least one positive terminal 251 is provided with a contact arm 253 extending along the circumference of the battery chamber. Preferably, the negative terminal 252 is arranged as an elastic sheet protruding outwards relative to the second circuit board 22. The elastic sheet is arranged to extend in different directions, providing secure contact with the battery 24. In one embodiment, as shown in the figure, adjacent elastic sheets extend substantially in an X-shape. The battery 24 may be pressed down in the direction indicated by D1 to enter the battery space enclosed by a plurality of positive terminals 251 and corresponding contact arms 253. In the case where the battery 24 is installed in the battery installation part 25, the positive terminal 251 and the contact arm 253 abut the side surface (positive pole) of the button battery, and the elastic sheet abuts, by being compressed, the negative pole of the button battery.

In some other embodiments, the battery 24 may further be a battery other than a button battery, for example, an AAA battery. It is understandable that the structure of the battery installation part 25 needs to be adjusted flexibly with changes in the shape of the battery.

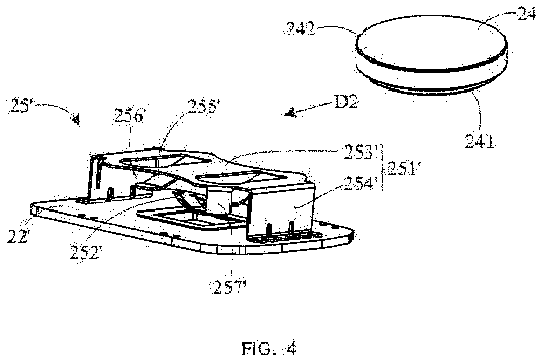

Fig. 4 is a battery installation part 25' having another structure, which comprises a positive terminal 251' and a negative terminal 252'. The positive terminal 251' is constructed to comprise two sidewalls 254' connected to the second circuit board 22' and extending upwards from the upper surface of the second circuit board 22'. These two sidewalls 254' are arranged opposite each other. The top wall 253' is connected to these two sidewalls 254' at a distance from the second circuit board 22'. Thus, the positive terminal 251' has a substantially n-shaped cross section, forming a space therein for accommodating the battery 24, and forming an opening at a transverse end for installing and removing the battery 24. The battery 24 may be installed into the battery installation part 25' from the opening in the direction indicated by D2 or removed from the battery installation part 25' in the opposite direction of D2. D2 is substantially parallel to the plane where the second circuit board 22' is located.

The top wall 253' is provided with an elastic sheet 255' extending obliquely towards the second circuit board 22'. Preferably, the angle between the component of the extension direction of the elastic sheet 255' in the direction parallel to the second circuit board 22' and the installation direction of the battery 24 is smaller than 90°. Further preferably, the angle between the two directions is zero. Preferably, the free end of the elastic sheet 255' is formed with a bent part 256' that extends parallel to or away from the second circuit board 22'. The bent part 256' is formed with a rounded or bent angle on the side facing the battery 24, providing smooth contact between the elastic sheet 255' and the battery 24. Preferably, a blocking part 257' extending towards the second circuit board 22' is provided at one end of the top wall 253' opposite to the battery installation opening. When the battery 24 is installed in place, the blocking part 257' prevents further movement of the battery 24 in the D2 direction, so that the battery 24 will not come off. In some embodiments, the top wall 253' may be integrally formed using metal sheets by processes such as bending and stamping.

The negative terminal 252' is constructed to comprise at least one elastic sheet. One end of the elastic sheet is fixed on the second circuit board 22', and the other end thereof is formed as a free end obliquely extending towards the top wall 253' relative to the surface of the second circuit board 22'. Preferably, the angle between the component of the extension direction of the elastic sheet in the direction parallel to the second circuit board 22' and the installation direction of the battery 24 is smaller than 90°. Further preferably, the angle between the two directions is zero. The free end of the elastic sheet may be formed with a rounded or bent angle to come into smooth contact with the battery 24.

Referring back to Fig. 4, it is clear that the battery 24, as a button battery, is usually constructed in the shape of a circular pie, with a first end 241 and a second end 242 along the thickness direction, at which the positive and negative electrodes of the button battery are formed, respectively. Specifically, these two ends have different radial sizes. For example, the first end 241 may be formed as a negative electrode, and the second end 242 may be formed as a positive electrode. The radial size of the first end 241 is smaller than the radial size of the second end 242. Indeed, in some other embodiments, the first end 241 may be formed as a negative electrode and the second end 242 may be formed as a positive electrode. During installation, the button battery may be installed along the insertion direction D2 from the opening of the battery installation part 25' (also known as the battery installation opening) into the battery installation part 25'. The insertion direction D2 is parallel to a radial direction of the button battery.

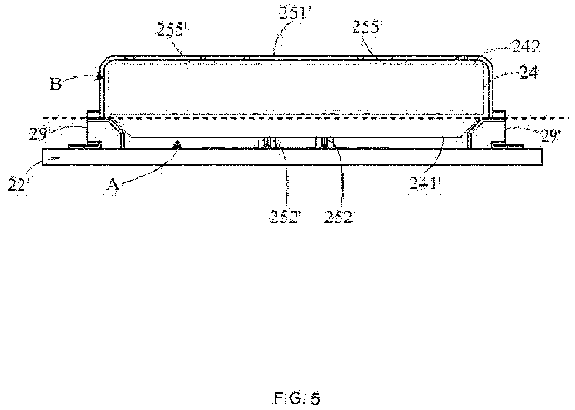

According to the present application, the battery installation part 25' is provided with a battery foolproof structure 29', which can, on the basis of the structure of the battery 24, prevent the positive and negative poles of the battery 24 from being reversed. Referring to Fig. 5, the battery foolproof structure 29' is at least partially arranged at the battery installation opening of the battery installation part 25'. Along the thickness direction of the battery 24, the battery installation opening is divided into a first passage part A and a second passage part B by the battery foolproof structure 29'. The passage size of the first passage part A is larger than the radial size of the first end part 241 of the battery 24, but smaller than the radial size of the second end part 242. In addition, the passage size of the second passage part B is greater than the radial size of the second end 242. Thus, during installation, the battery 24 can pass through the battery installation opening only when the first end 241 corresponds to the first passage part A and the second end 242 corresponds to the second passage part B. If an operator accidentally inserts the battery 24' into the battery installation part 25' in the opposite direction (in which the first end 241 corresponds to the second passage part B and the second end 242 corresponds to the first passage part A), since the passage size of the first passage part A is smaller than the radial size of the second end 242, the battery 24 will be blocked and unable to pass through the battery installation opening, thereby calling the operator's attention to the incorrect orientation of the battery 24, which needs to be corrected before installation can proceed smoothly.

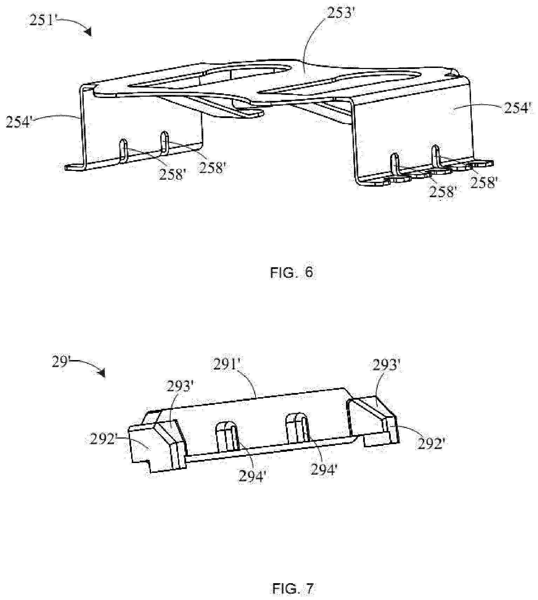

In some embodiments, the battery foolproof structure 29' may be attached to the positive terminal 251' of the battery installation part 25' to divide the battery installation opening. Referring to Fig. 5 to Fig. 7, the battery foolproof structure 29' may be specifically attached to a sidewall 254' of the positive terminal 251'. For example, the battery foolproof structure 29' may have a main body 291' extending along the insertion direction D2 of the battery 24, on which a snap protrusion 294' is provided. Correspondingly, the sidewall 254' of the positive terminal 251' is provided with a snap groove 258'. The battery foolproof structure 29' may be attached to the positive terminal 251' by a snap-in fit between the snap protrusion 294' and the snap groove 258'. In some embodiments, a snap groove may also be arranged on the battery foolproof structure 29', and a corresponding snap protrusion may be arranged on the positive terminal 251'. Alternatively, a snap protrusion and a snap groove may be installed on both the battery foolproof structure 29' and the positive terminal 251'.

In addition, an end of the main body 291' is provided with a protrusion 292'. In the case where the main body 291' is attached to the positive terminal 251', the protrusion 292' extends into the battery installation opening of the battery installation part 25'. As shown in Fig. 5, when observed along the insertion direction D2 of the battery 24, the protrusion 292' is located within the projection range of the battery installation opening. Thus, the portion corresponding to the protrusion 292' along the thickness direction of the battery 24 in the battery installation opening is formed as the first passage part A, and another portion is formed as the second passage part B. In some embodiments, a chamfer 293' is provided on the inner side of the protrusion 292' so that the passage size of the first passage part A gradually decreases in a direction away from the second passage part B, thus better adapting to the shape of the button battery.

In some embodiments, both ends of the main body 291' of the battery foolproof structure 29' are provided with protrusions 292'. Thus, the battery installation opening of the battery installation part 25' and another opening opposite to the battery installation opening can both achieve a foolproof effect. This is beneficial when no blocking part 257' is arranged in the battery installation part 25'. In some embodiments, the battery installation part 25' may be provided with two battery foolproof structures 29', which are symmetrical about the mid-separate surface of the battery installation part 25' (the mid-separate surface is parallel to the insertion direction D2 of the battery 24). In some embodiments, the battery foolproof structure may be clamped onto the sidewall 254' of the positive terminal 251' by a protrusion 292'. The protrusion 292' may be provided with an inverted buckle on the side in contact with the sidewall 254' (that is, the inner side of the sidewall 254' away from the main body 291'). When the battery foolproof structure 29' is installed onto the positive terminal 251', the reverse buckle fastens the sidewall 254' of the positive terminal 251'.

It is understandable that in some other embodiments, the battery foolproof structure may also be attached to the top wall of the positive terminal. In addition, a method of connecting the two is not limited to a snap fit. For example, the battery foolproof structure may be integrated with the positive terminal by injection moulding or connected to the positive terminal by fasteners. In some embodiments, the battery foolproof structure may be made of insulating materials to prevent any short circuits that are caused when the battery foolproof structure and the positive terminal come into contact with different electrodes of the battery, respectively.

In the above description, the term "horizontal" may be understood as the direction substantially parallel to the plane where the second circuit board is located, while "vertical" may be understood as the direction substantially perpendicular to the plane where the second circuit board is located. In addition, positive and negative terminals are used as examples for explanation. In some embodiments, the terminals 251 and 251' may be used as negative terminals, while the terminals 252 and 252' may be used as positive terminals.

Optionally, a removable insulation sheet may be provided between a battery and an elastic sheet. Before using the wireless tag, a user removes the insulation sheet so that the battery gets connected. Thus, the battery may be selectively preinstalled in the battery installation part.

The first circuit board 21 is constructed as a U-shaped structure with two opposite side arm parts, wherein the two opposite side arm parts may be used as guide rails. Correspondingly, the wireless communication module 23 is formed with grooves 231 on two opposite sides. The wireless communication module 23 is installed on the first circuit board 21 by a fit between the side arm part and the groove 231. Preferably, one end of the groove 231 facing the first circuit board 21 is provided with a chamfer 232, which makes it convenient to align the side arm part with the groove 231.

The first circuit board 21 is electrically connected to the wireless communication module 23 through the first connector 26. The first connector 26 is constructed as a pin connector. The first circuit board 21 is provided with a connection hole 212 into which one end of the pin connector is pluggable. The wireless communication module 23 is provided with a socket 233 into with the other end of the pin connector is pluggable. Preferably, the direction of plugging of the pin connector into the socket 233 of the wireless communication module 23 is parallel to the extension direction of the groove 231. The socket 233 is arranged at the end of the wireless communication module 23 facing the first circuit board 21. The direction of plugging of the pin connector into the connection hole 212 of the first circuit board 21 is perpendicular to the extension direction of the groove 231. In other words, the pin connector has an L-shaped pin structure. Thus, an electrical connection may be established between the first connector 26 and the wireless communication module 23 while the wireless communication module 23 is installed onto the first circuit board 21, and the plugging of the first connector 26 into the wireless communication module 23 has no negative impact on the connection between the first connector 26 and the first circuit board 21.

The second circuit board 22 and the first circuit board 21 are further electrically connected through the second connector 27, so that the electric energy of the battery 24 is supplied to the wireless communication module 23 through the second circuit board 22 and the first circuit board 21. As shown in Fig. 3, the second connector 27 is constructed as pin connectors, the number of which may be set as needed. For example, the number of second connectors 27 may be equal to the number of pins of the first connector 26. The first circuit board 21 is provided with a connection hole 211, and the second circuit board 22 is provided with a connection hole 221. The two ends of a pin of the pin connector are respectively inserted into the connection holes 211 and 221 to establish an electrical connection between the first circuit board 21 and the second circuit board 22. Preferably, the first circuit board 21 and the second circuit board 22 are stacked to allow a reduction in size. Preferably, the first circuit board 21 and the second circuit board 22 are spaced at predetermined intervals along the stacking direction. Thus, a space is formed between the two to accommodate at least a portion of the wireless communication module, thereby allowing a further reduction in the overall size of the functional assembly 20. Preferably, the second connector 27 comprises a support member 271 sleeved on the pins. In an installed state, the support member 271 is supported between the first circuit board 21 and the second circuit board 22, so that they are spaced at predetermined intervals. A plurality of second connectors 27 may be provided and spaced at intervals along the length direction of the U-shaped structure of the first circuit board 21 to achieve stable support between the first circuit board 21 and the second circuit board 22. In some embodiments, the second circuit board may further be provided with a controller or control circuit to control the wireless communication module. The controller is electrically connectible to the wireless communication module through a second connector, a first circuit board, and a first connector.

During assembly, the first circuit board 21 and the second circuit board 22 may first be connected through the second connector 27, and at the same time, the first connector 26 is plugged into the first circuit board 21. Then, the battery 24 is installed onto the battery installation part 25 on the second circuit board 22, and the wireless communication module 23 is installed on the first circuit board 21, wherein, at the same time, a connection is established between the wireless communication module 23 and the first connector 26. At this point, the installation of the functional assembly 20 is complete. Then, the functional assembly 20 is arranged in the housing 10 to complete the connection between the first housing 11 and the second housing 12. Preferably, as shown in Fig. 2, a bias member 28 may also be provided within the housing 10, which is elastically abutted between the inner wall of the housing 10 and the functional assembly 20 to ensure that the functional assembly 20 remains stable within the housing 10, rather than vibrating. The bias member 28 may be an elastic body, such as a spring, rubber pad, or sponge pad.

According to the present application, a wireless tag may be associated with any object to be located, tracked, or monitored, such as a power tool, battery pack, or household appliance. A communication protocol adopted by the wireless communication module of a wireless tag may be Bluetooth, Bluetooth Low Energy (BLE), radio frequency identification (RFID) technology, near-field communication (NFC) technology, etc. By a specific communication protocol, a wireless tag can establish wireless communication connections to electronic devices such as smartphones and tablet computers (for example, by specific applications preinstalled on the electronic devices). After a communication connection is established, an electronic device can obtain relevant information, such as the location and battery level of the wireless tag, from the wireless tag. In addition, when a wireless tag is provided with sensors, an electronic device can also obtain information sensed by the sensors from the wireless tag, such as ambient temperature, humidity, air pressure, longitude and latitude, or states of the associated object (such as motion status and whether any vibrations occur).

In the case where wireless communication is maintained between a wireless tag and an electronic device, a command may also be issued by the electronic device to the wireless tag, so that the wireless tag performs corresponding operations according to the command. For example, an electronic device can also determine the location of a wireless tag by sending a search instruction. Upon receiving a search instruction from an electronic device, the wireless tag sends prompt information to help the operator discover the wireless tag and associated object. In some embodiments, the prompt information may include a light signal. A wireless tag may be provided with a luminous apparatus, for example, an LED lamp. In response to receiving the search instruction, the light emitting apparatus may flash periodically, for example once every 400 ms. Such a setting is advantageous in a darker environment. In some embodiments, the prompt information may include a sound signal. For example, a wireless tag may be provided with a buzzer or speaker configured to emit sound signals in response to receiving a search instruction. The sound signals preferably may be a combination of syllables of different lengths and/or pitch levels, for example, a prompt tone comprising 1 long beep and 2 short beeps, namely "beep-, beep beep", or a voice prompt, etc.

Preferably, a wireless tag is configured to stop emitting any prompt information when the prompt information has lasted a predetermined duration. The duration may be set on the basis of the complexity of the environment in which the wireless tag is located, for example, to 1 min, so that the operator can discover the wireless tag in a timely manner. A wireless tag may further be provided with an operable switch. When the operator discovers the wireless tag within the duration, the operator can, by operating the switch, stop the wireless tag from emitting any prompt information. The switch may be in the form of a button or toggle. In addition, this switch may also be used to activate a wireless tag. Preferably, only one switch is arranged, and different functions are achieved by different methods of operating the switch, such as long pressing the switch for a predetermined time to activate the wireless tag, short pressing the switch to stop sending prompt information, etc.

In addition, the functional assembly of the wireless tag may also be provided with a storage module for recording information. Recorded information may specifically comprise, for example, the duration of use of the wireless tag or associated object, position change information, motion information, and error events that occur during the use of the wireless tag. Preferably, when a communication connection is established between an electronic device and a wireless tag, the electronic device can read the recorded information in the storage module to understand historical information about the wireless tag and the object associated therewith. In addition, when the storage space of the storage module is used up, newly generated record information overwrites the earliest piece of recorded information to prevent failure to record information due to insufficiency of storage space.

Further, according to a technical solution of the present application, the wireless communication module of the wireless tag is further configured to be able to broadcast information to the outside when its communication connection to an electronic device is broken. The broadcast information may comprise the location and battery level of the wireless tag and information sensed by sensors. The advantage of such a setting is that it eliminates the need to establish a communication connection between an electronic device and a wireless tag before information can be received, thus allowing for simpler and more convenient operation steps.

Preferably, in the case where the wireless tag has not established any communication connection to the electronic device, it can send broadcast information to the outside periodically, for example, every 2s. Within a predetermined range from the wireless tag (that is, when a wireless signal loaded with broadcast information has sufficient strength to be sensed), an electronic device installed with a specific application can receive the broadcast information, so that status information about each device is obtainable without establishing a communication connection. In some embodiments, an electronic device may further, upon receiving broadcast information, initiate a communication request and complete identity authentication through handshake requests, thus establishing a wireless communication connection to the wireless tag. In some embodiments, to remind an operator of an electronic device to establish a communication connection, broadcast information sent by a wireless tag without a communication connection may further comprise a recommended connection request identifier.

The above description of a plurality of embodiments of the present application is provided for illustrative purposes to a person of ordinary skill in the art. It is not intended that the present application be exclusive or be limited to a single disclosed embodiment. On the basis of what are described above, those of ordinary skill in the art will understand various substitutes for and variants of the present application. Therefore, although some alternative embodiments have been described specifically, a person of ordinary skill in the art will understand or develop with relative ease other embodiments. The present application is intended to include all alternatives, modifications and variants of the present application described herein, as well as other embodiments which fall within the spirit and scope of the present application described above.

## Claims

1. Wireless tag, **characterised in that** the wireless tag comprises
a wireless communication module (23) configured to wirelessly communicate with an external electronic device;
a control circuit board module comprising a first circuit board (21) and a second circuit board (22) that are spaced and stacked and electrically connected, wherein the wireless communication module (23) is installed on the first circuit board (21) and at least partially located in the space between the first circuit board (21) and the second circuit board (22); and
a battery (24), which is used for powering the wireless tag and installed on the second circuit board (22).

2. Wireless tag according to Claim 1, **characterised in that** the first circuit board (21) comprises a U-shaped structure, and **in that** the wireless communication module (23) is a separate structure from the first circuit board (21) and at least partially embedded in the space enclosed by the U-shaped structure.

3. Wireless tag according to Claim 2, **characterised in that** a chute (231) is provided on a side of the wireless communication module (23), and **in that** two opposite side arms of the U-shaped structure are slidably arranged in the chute (231).

4. Wireless tag according to Claim 3, **characterised in that** one end of the chute (231) facing the first circuit board (21) is provided with a chamfer (232), wherein preferably, a slanted face is provided on the inner side of the U-shaped structure, and in a state where the wireless communication module (23) is embedded in the first circuit board (21), the slanted face fits the chamfer (232), or
the chute (231) is provided with a limit protrusion that protrudes outwards, or
the wireless communication module (23) is connected to the first circuit board (21) through a pin connector, wherein the direction of plugging of the wireless communication module (23) into the pin connector is parallel to the sliding direction of a side arm of the U-shaped structure in the chute (231), and the direction of plugging of the pin connector into the first circuit board (21) is perpendicular to the sliding direction.

5. Wireless tag according to Claim 1, **characterised in that** the first circuit board (21) and the second circuit board (22) are electrically connected through a pin connector, the pin connector comprising a support member (271) sleeved on a pin, the support member (271) being supported between the first circuit board (21) and the second circuit board (22).

6. Wireless tag according to Claim 1, **characterised in that** a battery installation part (25) is provided on one side of the second circuit board (22) away from the wireless communication module (23), the battery (24) is installed and fixed through the battery installation part (25), the battery (24) is a button battery, and the battery installation part (25) comprises a first terminal (252) that protrudes elastically outwards from the surface of the second circuit board (22) and a plurality of second terminals (251) that extend outwards from the surface of the second circuit board (22) around the first terminal (252), wherein in the state where the button battery is installed in the battery installation part (25), the first terminal (252) elastically abuts an end face of the button battery, and the second terminal (251) abuts the side of the button battery,
wherein, preferably, the first terminal (252) comprises at least two elastic sheets, one end of which is fixed on the second circuit board (22) and the other end of which is formed as a free end extending outwards obliquely relative to the surface of the second circuit board (22), wherein adjacent elastic sheets are arranged in an X-shaped cross, or at least one of the second terminals (251) is provided with an elastic contact arm (253) extending along the circumference of the button battery.

7. Wireless tag according to Claim 1, **characterised in that** a battery installation part (25) is provided on one side of the second circuit board (22) away from the wireless communication module (23), the battery (24) is installed and fixed through the battery installation part (25), the battery (24) is a button battery, the battery installation part (25') comprises a first terminal (251') and a second terminal (252') that are spaced at intervals along the direction perpendicular to the plane of the second circuit board (22'), and the button battery is sandwiched between the first terminal (251') and the second terminal (252').

8. Wireless tag according to Claim 7, **characterised in that** the first terminal (251') comprises
two opposite sidewalls (254'), which are connected to the second circuit board (22') and extend in a direction away from the second circuit board (22'), and
a top wall (253') connected to two opposite sidewalls (254') at a distance from the second circuit board (22'), wherein, preferably, one end of the first terminal (251') is formed with a laterally facing battery installation opening, and the top wall (253') is provided with a first elastic sheet (255') extending obliquely towards the second circuit board (22').

9. Wireless tag according to Claim 8, **characterised in that** the first terminal (251') comprises a blocking part (257') arranged at one end opposite to the battery installation opening, wherein the blocking part (257') is configured to prevent further movement of the battery (24) along the installation direction, or the second terminal (252') comprises a second elastic sheet, one end of which is fixed to the second circuit board (22') and the other end of which is formed as a free end facing outwards relative to the surface of the second circuit board (22') and extending obliquely away from the battery installation opening.

10. Wireless tag according to Claim 1, **characterised in that** the wireless tag further comprises a battery installation part (25') for installing a battery (24), the battery (24) being used for powering the wireless tag, wherein the battery installation part (25') is provided on the second circuit board and has a battery foolproof structure (29') that can prevent the positive and negative electrodes of the battery (24) from being reversed, wherein, preferably, the battery foolproof structure (29') is an insulated foolproof structure.

11. Wireless tag according to Claim 10, **characterised in that**
the battery (24) is a button battery having a first end (241) and a second end (242) opposite to each other along the thickness direction, the radial size of the first end (241) is smaller than that of the second end (242), the first end (241) forms one of the positive and negative electrodes of the button battery, and the second end (242) forms the other of the positive and negative electrodes of the button battery;
the battery installation part (25') has a battery installation opening and is constructed to allow the button battery to be plugged into the battery installation part (25') radially along its own direction through the battery installation opening, and the battery foolproof structure (29') is at least partially located at the battery installation opening, wherein the battery foolproof structure (29') divides the battery installation opening into a first passage part (A) and a second passage part (B) along the thickness direction of the button battery, the first passage part (A) having a passage size greater than the radial size of the first end (241) of the button battery and smaller than the radial size of the second end (242) of the button battery, the second passage part (B) having a passage size greater than the radial size of the second end (242) of the button battery.

12. Wireless tag according to Claim 11, **characterised in that** the battery installation part (25') comprises
a first terminal (251') having
two opposite sidewalls (254') connected to the circuit board and extending in a direction away from the circuit board, and
a top wall (253') connected to two opposite sidewalls (254') at a distance from the circuit board; and
a second terminal (252') provided on the second circuit board and opposite to the top wall (253').

13. Wireless tag according to Claim 12, **characterised in that** the battery foolproof structure (29') has a protrusion (292'), wherein the battery foolproof structure (29') is attached to the first terminal (251'), and when viewed in the direction of plugging of the button battery into the battery installation part (25'), the protrusion (292') is located within the projection range of the battery installation opening.

14. Wireless tag according to Claim 13, **characterised in that** a chamfer (293') is provided on the inner side of the protrusion (292'), so that the passage size of the first passage part (A) gradually decreases in the direction away from the second passage part (B); or
the battery foolproof structure (29') comprises two, which are symmetrically arranged relative to a mid-separate surface that is parallel to the direction of plugging of the button battery and bisects the first terminal (251'); or
the battery foolproof structure (29') has a main body (291') extending along the direction of plugging of the button battery, wherein the main body (291') is provided with a snap protrusion and/or a snap groove, and the first terminal (251') is provided with a snap groove and/or a snap protrusion, the battery foolproof structure (29') being attached to the first terminal (251') through a snap fit between a snap protrusion and a snap groove, wherein, preferably, the main body (291') is provided with said protrusions (292') at both ends along its own length direction.

15. Wireless tag according to Claim 14, **characterised in that** the battery foolproof structure (29') is provided with an inverted buckle, which clamps tightly on the sidewall (254') of the first terminal (25 1').
